# EUROPÄISCHE PATENTANMELDUNG

(11) **EP 0 626 721 A1**
(43) Veröffentlichungstag der Anmeldung: **30.11.1994**
(21) Anmeldenummer: 94103914.1
(22) Anmeldetag: 14.03.1994
(51) Int. Cl.: H01L 21/263, H01L 21/308, B24C 1/00

(54) **Verfahren zur Erzeugung eines Oberflächenprofils in einer Oberfläche eines Substrats**

(30) Priorität: 06.04.1993 DE 4311289
(71) Anmelder: SIEMENS AKTIENGESELLSCHAFT, D-80333 München (DE)
(72) Erfinder: Wenger, Gundolf, D-81549 München (DE); Müller, Gustav, Dr., D-80993 München (DE)

(57) **Zusammenfassung**

2.1 Es wird ein sehr einfaches Verfahren zur Erzeugung eines Oberflächenprofils (13) in der Oberfläche (10) eines Substrats (1) beschrieben, das vielseitig verwendbar ist und sehr gut reproduzierbare Oberflächenprofile besonders hoher Genauigkeit ermöglicht.

2.2 Dazu wird in einem Abstand (d) über der Oberfläche (10) eine Maske (2) mit einer Maskenkante (20) vorgesehen, die Oberfläche (10) mit einem ätzenden Ionenstrahl (3) bestrahlt, und während der Bestrahlung die Oberfläche (10) um eine schräg im Winkel (α) zur Richtung (30) des Ionenstrahls (3) angeordnete Drehachse (4), die senkrecht zur Oberfläche (10) steht, gedreht, wobei der Strahl (3) während des Drehens die Maskenkante (20) trifft. Durch Variation des Winkels (α) können beliebig vorgegebene Oberflächenprofile erzeugt werde.

2.3 Anwendung bei der Herstellung von Schichttapern in Halbleitermaterial

## Beschreibung

Zur Herstellung von Oberflächenprofilen in der Oberfläche von Substraten ist vorgeschlagen worden, auf die Oberfläche Materialien mit örtlich variierenden Schichtdicken aufzubringen, die in einem anschließenden Trockenätzprozeß als Ätzmaske dienen. Als Materialien für die Ätzmasken sind Photolacke und verschiedene Oxide, beispielsweise Aluminiumoxid oder Siliziumoxid vorgeschlagen worden. Das in der Oberfläche entstehende Oberflächenprofil hängt von dem Ätzratenverhältnis zwischen dem Material des Substrats und dem Material der Ätzmaske ab. Das vorgeschlagene Verfahren wird beispielsweise zur Strukturierung von Halbleiterschichtstrukturen verwendet.

Der im Anspruch 1 angegebenen Erfindung liegt die Aufgabe zugrunde, ein zum vorgeschlagenen Verfahren alternatives, sehr einfaches Verfahren bereitzustellen.

Mit dem vielseitig verwendbaren erfindungsgemäßen Verfahren lassen sich Oberflächenprofile sehr gut reproduzierbar mit sehr hoher Genauigkeit auf einfache Weise herstellen. Das Verfahren ist zur Erzeugung von definierten Oberflächenprofilen, beispielsweise Schichttapern, besonders geeignet.

Beliebige vorgegebene Oberflächenprofile lassen sich bei dem erfindungsgemäßen Verfahren vorteilhafterweise durch zeitliche Variation des Winkels der Drehachse zur Richtung des Strahls und/oder zur Oberfläche des Substrats (Anspruch 2) erzeugen.

Vorzugsweise wird die Drehachse nicht schräg, sondern gemäß Anspruch 3 senkrecht zur Oberfläche des Substrats angeordnet.

Wenn bei dem erfindungsgemäßen Verfahren die Oberfläche gemäß Anspruch 4 während des Bestrahlens und Drehens mit einem berührungslos arbeitenden Meßgerät, insbesondere einem interferometrischen optischen Meßgerät (Anspruch 5) vermessen wird, kann vorteilhafterweise das gewünschte Oberflächenprofil während der Entstehung hinsichtlich Genauigkeit und Form überwacht werden und es laßt sich überdies eine volle Kompatibilität zur On-Line-Kontrolle erreichen.

Die Erfindung wird in der nachfolgenden Beschreibung anhand der Figuren beispielhaft näher erläutert. Es zeigen:
- Figur 1: in schematischer Darstellung eine Anordnung zur Durchführung des erfindungsgemäßen Verfahrens, und
- Figur 2: im maßstäblichen Querschnitt ein Beispiel eines mit der Anordnung nach Figur 1 hergestellten Oberflächenprofils.

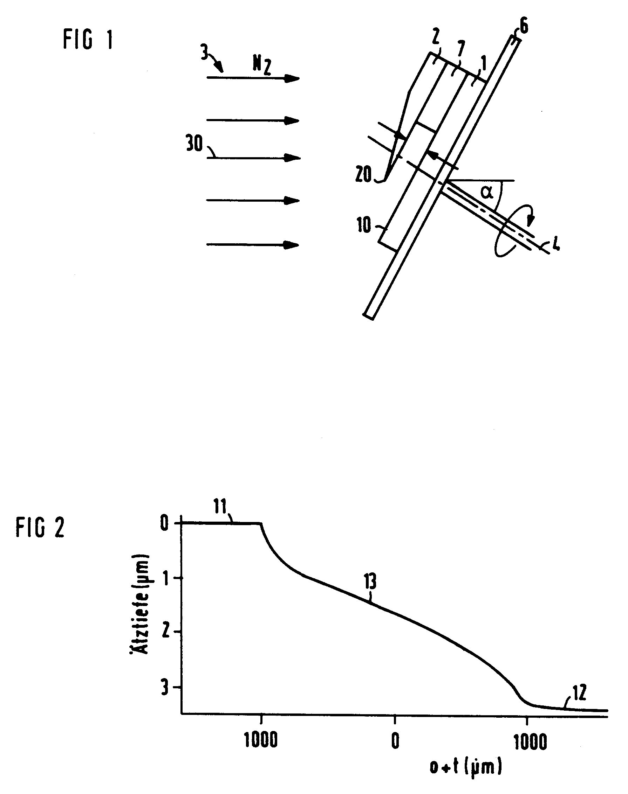

Gemäß Figur 1 ist das Substrat 1 auf einem drehbaren Teller 6 angeordnet, der um die Drehachse 4 drehbar ist.

Über der vom Teller 6 abgekehrten Oberfläche 10 des Substrats 1 ist in einem bestimmten Abstand d von dieser Oberfläche 10 die abdeckende Maske 2 mit der definierten Maskenkante 20 angeordnet. Der Abstand d der Maske 2 und Maskenkante 20 von der Oberfläche 10 ist durch einen zwischen der Oberfläche 10 und der Maske 2 angeordneten Abstandshalter 7 definiert.

Die Maske 2 mit der Maskenkante 20, der Abstandshalter 7 und das Substrat 1 sind zusammen mit dem Teller 6 bezüglich der Drehachse 4 drehfest und beispielsweise in einer nicht dargestellten Ionenstrahlätzkammer angeordnet, in welcher der in der bestimmten Richtung 30 auf die Oberfläche 10 gerichtete Material abtragende Strahl 3 in Form eines ätzenden Ionenstrahls erzeugt.

Während des Ätzvorganges wird der Teller 6 zusammen mit dem Substrat 1 und der Maske 2 um die zur Richtung 30 des Strahls 3 schräg im Winkel α angeordnete Drehachse 4 gedreht, wobei der Strahl 3 während des Drehens des Substrats 1 auf die Maskenkante 20 trifft. Dadurch wird erreicht, daß verschiedene Bereiche der Oberfläche 10 unterhalb der Maske 2 unterschiedlich lange dem Strahl 3 ausgesetzt sind. Dies hat einen ortsabhängigen Materialabtrag zur Folge. Durch zeitliche Variation des Winkels α können beliebig vorgegebene Oberflächenprofile erzeugt werden, wobei in diesem Fall der Winkel α auch den Wert 0 annehmen kann.

Im Beispiel nach der Figur 1 liegt die nicht notwendige, aber bevorzugte Besonderheit vor, daß die Oberfläche 10 des Substrats 1 und die Drehachse 4 zueinander senkrecht sind. Ist dies nicht der Fall, taumelt die Oberfläche 10 gleich einer Taumelscheibe um die Drehachse 4, ein Effekt, der bei dem erfindungsgemäßen Verfahren ebenfalls ausgenutzt werden kann, wobei in diesem Fall die Richtung 30 des Strahls 3 auch parallel zur Drehachse 4 sein könnte.

Der Strahl 3 ist im Beispiel nach der Figur 1 ein Parallelstrahl. Dies ist nicht erforderlich, vielmehr ist in der Praxis der Strahl 3 eher ein divergenter, weniger ein konvergenter Strahl, wobei in diesen Fällen die Richtung durch die Achse bzw. Hauptrichtung des betreffenden Strahls gegeben ist.

Nach Beendigung des Verfahrens weist die Oberfläche 10 gemäß Figur 2 in jedem Fall zwei auf verschiedenen Niveaus liegende Oberflächenbereiche 11 und 12 auf, die durch einen das erzeugte Oberflächenprofil aufweisenden Übergangsbereich 13 unterhalb der Maskenkante miteinander verbunden sind. Der auf dem hohen Niveau liegende Oberflächenbereich 11 ist ein ungeätzter Bereich, während der tief liegende Oberflächenbereich 12 der am tiefsten geätzte Bereich ist.

Das Oberflächenprofil 13 hängt u.a. von der Querschnittsform der Maskenkante 20 ab. Ist die Maskenkante 20 wie in Figur 1 eine scharfe Schneide, ist das Oberflächenprofil 13 steiler als in den Fällen, in denen die Maskenkante 20 mehr oder weniger stumpf ist.

Das in Figur 2 im Maßstab gezeigte Beispiel eines konkreten Oberflächenprofils im Übergangsbereich 13 zwischen den Oberflächenbereichen 11 und 12 verschiedenen Niveaus wurde beispielsweise mit einem N₂-Ionenstrahl hergestellt. Die Ionenstrahlquelle befand sich etwa 0,5 m vom Substrat 1 entfernt. Bei einem Winkel α von π/4 und einem Abstand d = 1000 µm der Maske 2 von der Oberfläche 10 des Substrats 1 entstand des in Figur 2 gezeigte Oberflächenprofil, wobei 0 auf der waagerechten Abszisse die Position der Maskenkante 20 markiert.

## Patentansprüche

1. Verfahren zur Erzeugung eines Oberflächenprofils (13) in einer Oberfläche (10) eine s Substrats 1),
**gekennzeichnet durch**
- Versehen des Substrats (1) mit einer dessen Oberfläche (10) abdeckenden und in einem bestimmten Abstand (d) von dieser Oberfläche (10) angeordneten Maske (2) mit einer definierten Maskenkante (20),
- Bestrahlen der Oberfläche (10) mit einem in einer bestimmten Richtung (30) auf die Oberfläche (10) gerichteten, materialabtragenden Strahl (3), und
- Drehen des Substrats (1) zusammen mit der Maske (2) um eine zur Richtung (30) des Strahls (3) und/oder zur Oberfläche schräg in einem Winkel (α) angeordnete Drehachse (4) während des Bestrahlens, wobei der Strahl (3) während des Drehens des Substrats (1) auf die Maskenkante (20) trifft.

2. Verfahren nach Anspruch 1,
**dadurch gekennzeichnet,**
daß der Winkel (α) der Drehachse (4) zur Richtung (30) des Strahls (3) und/oder der Oberfläche (10) zeitlich variiert wird.

3. Verfahren nach Anspruch 1,
**dadurch gekennzeichnet,**
daß die Drehachse (4) und die Oberfläche (10) senkrecht zueinander sind.

4. Verfahren nach einem der vorhergehenden Ansprüche,
**dadurch gekennzeichnet,**
daß die Oberfläche (10) wahrend des Bestrahlens und Drehens mit einem berührungslos arbeitenden Meßgerät (5) vermessen wird.

5. Verfahren nach Anspruch 4,
**dadurch gekennzeichnet,**
daß die Oberfläche (10) mit einem interferometrischen optischen Meßgerät (5) vermessen wird.
